# EUROPEAN PATENT SPECIFICATION

(11) **EP 1 489 379 B1**
(45) Date of publication and mention of the grant of the patent: **13.04.2016**
(21) Application number: 04014053.5
(22) Date of filing: 16.06.2004
(51) Int. Cl.: G01C 19/56

(54) **Piezoelectric device, method of manufacturing it and electronic equipment comprising such a device**
Piezoelektrisches Bauteil, Verfahren zu seiner Herstellung und elektronisches Gerät mit solch einem Bauteil
Dispositif piézoélectrique, procédé de sa fabrication et équipement électronique comportant un tel dispositif

(30) Priority: 19.06.2003 JP 2003175020
(43) Date of publication of application: 22.12.2004
(73) Proprietor: Seiko Epson Corporation, Shinjuku-ku Tokyo 163-0811 (JP)
(72) Inventor: Kinoshita, Yusuke, Suwa-shi, Nagano-ken 392-8502 (JP)
(74) Representative: MERH-IP Matias Erny Reichl Hoffmann Patentanwälte PartG mbB

(56) References cited:
- EP-A- 0 553 718
- EP-A2- 0 881 465
- DE-A1- 19 800 333
- JP-A- 2001 296 128
- US-A1- 2002 166 380
- PATENT ABSTRACTS OF JAPAN vol. 2002, no. 02, 2 April 2002 (2002-04-02) & JP 2001 304870 A (TOKIN CORP), 31 October 2001 (2001-10-31)
- PATENT ABSTRACTS OF JAPAN vol. 2000, no. 21, 3 August 2001 (2001-08-03) & JP 2001 091259 A (TOKIN CERAMICS CORP), 6 April 2001 (2001-04-06)
- PATENT ABSTRACTS OF JAPAN vol. 2003, no. 09, 3 September 2003 (2003-09-03) & JP 2003 156511 A (SUMITOMO METAL IND LTD), 30 May 2003 (2003-05-30)

## Description

This invention relates to a piezoelectric device using a resonator element such as quartz, a manufacturing method of a piezoelectric device, and electronic equipment on which a piezoelectric device is mounted.

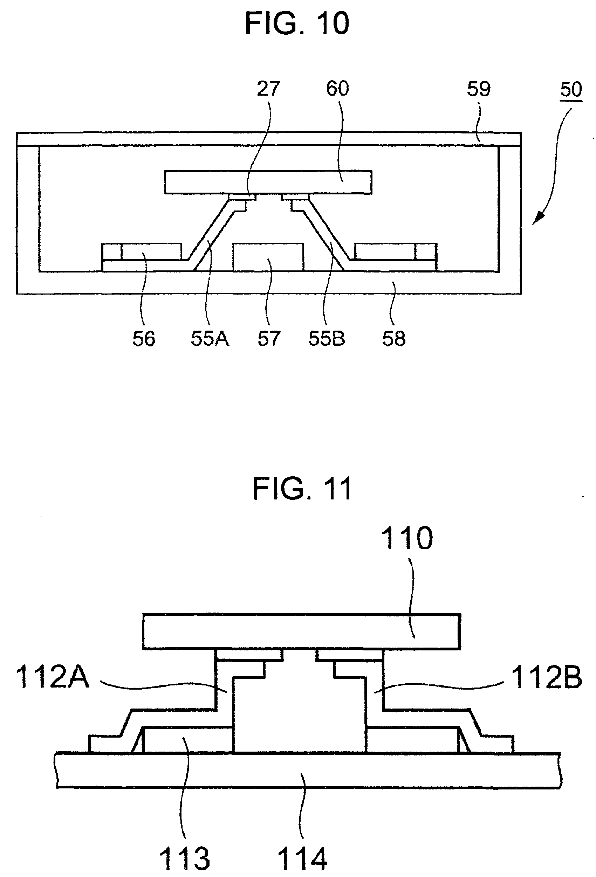

A configuration of a conventional piezoelectric device is shown in FIG. 11 and described below.

In the configuration of the conventional piezoelectric device, to a package 114, which is a substrate member, lead wires 112A and 112B which have one respective end affixed to a support substrate 113 are connected, and a piezoelectric resonator element 110 is connected to and held by the other ends of the lead wires 112A and 112B, respectively. The support substrate 113 is configured such that the lead wires 112A and 112B are affixed to a surface which is remote from the surface that faces the package 114.

According to the above-mentioned configuration, so as to secure close adhesion of the lead wires with the package 114 at a junction thereof, it was necessary to have them bent in accordance with the thickness of the support substrate present in between the lead wires and the package (hereinafter referred to as "lead forming").

Because of the lead wires being exposed on an upper surface, for example, due to a splash of deposited gold particles (hereinafter referred to as "Au splash") which occurs when tuning a vibration frequency of the resonator element, there was a problem of generating a short circuit between the lead wires.

Document DE 198 00 333 A discloses a piezoelectric device, wherein a lead wire is sandwiched between a piezoelectric resonator element and a support substrate. One end of the lead wire extends through a hole in the support substrate and is then soldered onto the side of the support substrate that faces away from the resonator element.

Document EP 0 553 718 discloses a piezoelectric device, wherein a piezoelectric resonator element is held by lead wires at a distance above a support substrate. A ground conductor pattern is formed on a lower surface of a support substrate. The lead wires are in contact with the ground conductor pattern at the lower side of the support substrate and extend through holes in the support substrate towards the piezoelectric resonator element.

Document JP 20014304870 A discloses a piezoelectric gyroscope, wherein a metallic support substrate is fixed with solder onto belt-like electrodes which are connected to a piezoelectric vibrator.

Document JP 2001091259 A discloses a piezoelectric gyroscope, wherein lead wires of a piezoelectric resonator element are sandwiched between supporting members on their upper and on their lower surface side.

Document JP 2001 296128 discloses a piezoelectric gyroscope, wherein lead wires are arranged in a horizontal plane within a support frame and wherein the lead wires further act as support members for a cylindrical piezoelectric resonator element arranged in the support frame.

Document EP 0 881465 A2 discloses a vibrating gyroscope, wherein a piezoelectric resonator element is held in a support frame by thin, flexible lead wires which are affixed to the top surface of the resonator element.

It is an object of the invention to enable the lead wires to adhere closely to the substrate without said so-called "lead forming" by affixing the lead wires to a lower surface of the support substrate, that is, a surface facing the package, and thus to dispense with lead forming processing. Another object of this invention is to prevent Au splash from depositing on the lead wires, by receiving the Au splash on the support substrate provided on an upper surface of the lead wires, thereby preventing a short circuit between the lead wires.

These objects are achieved by a piezoelectric device as claimed in claim 1 and a method of manufacturing it as claimed in claim 9. Preferred embodiments of this invention are subject-matter of the dependent claims.

According to the piezoelectric resonator element of this invention, since the lead wire is affixed to a lower surface of the support substrate, that is, a surface opposite to the package, it is possible to make the lead wire to adhere closely to the base substrate, thus dispensing with lead forming processing. Namely, it is possible to enhance ease of processing and to provide a piezoelectric device of low cost.

Also, receiving an Au splash on the support substrate located on the upper surface of the lead wire is made possible, so that a short circuit between lead wires may be prevented by keeping the Au splash from deposing on the lead wire.

Preferred embodiments of this invention and the achieved advantages will be described in detail below with reference to the drawings, in which:
- FIG. 1: is an explanatory diagram showing a configuration of a gyro sensor as an example of a piezoelectric device, FIG. 1 (A) being a plan view, and FIG. 1 (B) being a front view showing a section along the line a-a' in Fig. 1 (A);
- FIG. 2(A) to (C): are diagrams showing a motion of a drive arm;
- FIG. 3: is a diagram showing a relationship between the motion of the drive arm and the Coriolis force;
- FIG. 4(A) to (C): are diagrams showing a motion of a detection arm;
- FIG. 5: is a sectional view of a structure of a support substrate 22;
- FIG. 6: is an explanatory diagram showing a configuration of the gyro sensor as an example of the piezoelectric device, FIG. 6(A) being a plan view, and FIG. 6(B) being a front view showing a section along the line a-a' in Fig. 6a;
- FIG. 7(A) and (B): show diagrams illustrating connection methods of both ends of a lead wire;
- FIG. 8: shows a diagram illustrating application examples of a cut-out of the support substrate;
- FIG. 9: is a front sectional view showing an application example of this invention;
- FIG. 10: is a front sectional view showing a configuration of the piezoelectric device of this invention; and
- FIG. 11: is a diagram showing a configuration of a conventional piezoelectric device.

In this embodiment, a gyro sensor using a quartz resonator element will be used and described as an example.

### Gyro Sensor Configuration

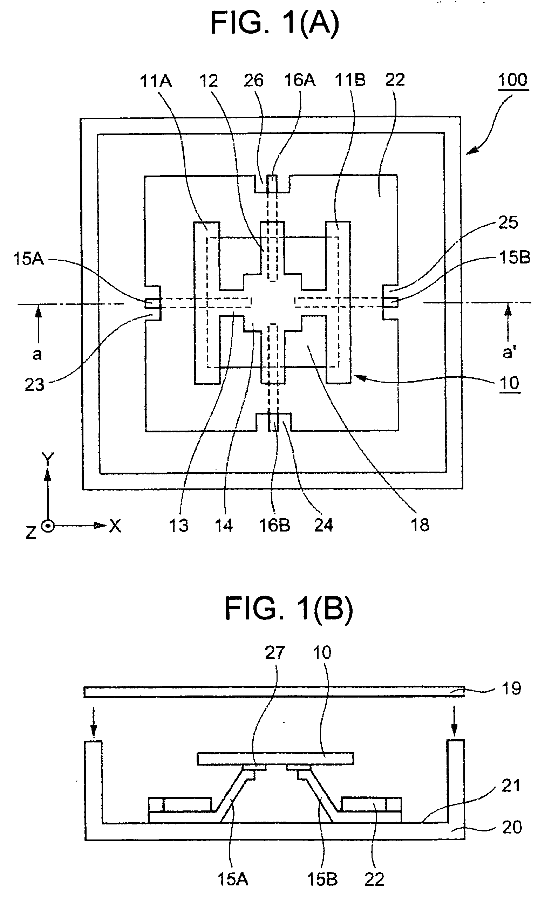

FIG. 1 is a diagram illustrating a configuration of a gyro sensor as an example of a piezoelectric device. FIG. 1(A) is a plan view, and FIG. 1(B) is a front view showing a section along a - a'.

According to FIG. 1, to detect a posture of an object such as an electronic equipment and a vehicle, a gyro sensor 100 is mounted thereon and used. The gyro sensor 100 comprises a gyro resonator element 10, which is a piezoelectric resonator element; lead wires 15A, 15B, 16A and 16B which are a support mechanism to support the resonator element 10; a support substrate 22; a package 20 made of, e.g., ceramic, accommodating the resonator element 10 supported by way of the lead wires and the support substrate 22 therein; and a cover 19 for the package 20.

### First Embodiment

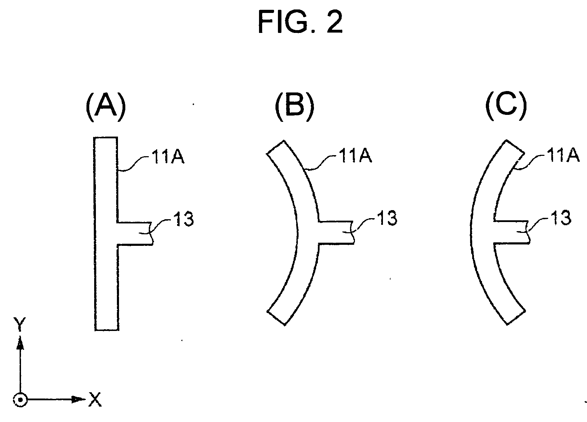

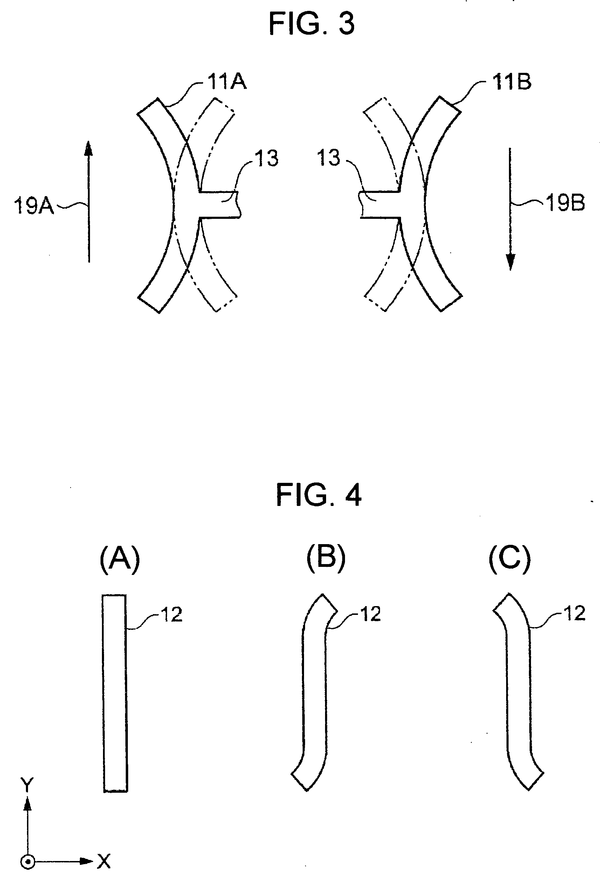

Referring to FIG. 1(A) and FIG. 1(B), a first embodiment will be described below using FIG. 2, FIG. 3, and FIG. 4. FIG. 2 shows a motion of a drive arm. FIG. 3 shows a relationship between the motion of the drive arm and the Coriolis force. FIG. 4 indicates the motion of a detecting arm.

### Configuration of Resonator Element

To operate in three modes known as drive mode, detection mode, and spurious mode, the resonator element 10 used in the gyro sensor 100 includes a first drive arm 11 A and a second drive arm 11 B which constitute a drive unit, a detection arm 12 which is a detection unit, an arm support part 13, and a support plate 14 which is a support part.

As shown in FIG. 1(A), the first and the second drive arm 11A and 11B are members in a plate shape having a prescribed length which respectively extend in an illustrated direction Y, that is, mutually in parallel. X, Y and Z in the following text refer to axes of a Cartesian coordinate system as defined in the Figures. The first and the second drive arm 11A and 11B are influenced, during vibration along the direction X, by the Coriolis force corresponding to the magnitude of the rotary angular velocity of a rotation around an axis that extends in direction Z, which is one variation of the posture of the object.

The drive arm 11A, as shown in FIG. 2(A)-2(C), vibrates according to a bending motion with its center as a fulcrum; to be more specific, the drive arm 11A is alternately deformed to a convex shape and a concave shape while vibrating, namely, the opposite longitudinal ends of the drive arm are displaced along the X axis relative to the longitudinal center of the drive arm 11 A. The drive arm 11B vibrates correspondingly such that its shape becomes axisymmetrical to that of the drive arm 11A.

FIG. 3 shows the relationship between the deformation of the drive arm and the Coriolis force. As shown in FIG. 3, while the first drive arm 11A deforms from the shape illustrated by a broken line to the shape illustrated by a solid line and the second drive arm 11 B also deforms from the shape illustrated by a broken line to the shape illustrated by a solid line, they are subjected to the Coriolis force along the arrows 19A and 19B, respectively, in response to a clockwise rotation in the plane of the drawing. In contrast, while the first drive arm 11A deforms from the shape illustrated by a solid line to the shape illustrated by a broken line and the second drive arm 11 B also deforms from the shape illustrated by a solid line to the shape illustrated by a broken line, the Coriolis force acts in directions opposite to the arrows 19A and 19B in response to the same clockwise rotation.

The detection arm 12 is, like the first drive arm 11A and the second drive arm 11B, a plate member having a prescribed length extending along the Y direction. Namely, the first drive arm 11A, the second drive arm 11 B, and the detection arm 12 are mutually parallel. To detect the Coriolis force acting on the first and the second drive arm 11A and 11B, the detection arm 12 responds to the Coriolis force conveyed from the first and the second drive arm 11A and 11B through the arm support 13 and vibrates corresponding to the magnitude of the Coriolis force.

The detection arm 12, as shown in FIG. 4(A)-4(C), performs a bending motion of deforming into shape substantially like the letter S and the reverse of the letter S, like the bending motion of the first and the second drive arm 11A and 11B shown in FIG. 3(A) - 3(C). By detecting an electric signal generated due to the bending motion of the detection arm 12, the magnitude of the Coriolis force is known, whereby the magnitude of the rotary angular velocity applied to the object is discerned.

Returning to FIG. 1 (A), one end of the arm support part 13 is connected to the center of the first drive arm 11 A, the other end is connected to the center of the second drive arm 11B, and the center of the arm support part 13 is connected to the detection arm 12 such that it corresponds to the center of the detection arm 12. The support plate 14 is a plate shape member having a prescribed area including the connection point of the arm support part 13 and the detection arm 12.

### Holding Structure of Resonator element

The lead wires 15A and 15B extending in the X direction and the lead wires 16A and 16B extending in the Y direction are band or stripe like members having the same or a different shape. A first end portion of each of the lead wires 15A, 15B, 16A and 16B is, as shown in FIG. 1 (B), connected to one side (the lower side in the figure) of the support plate 14 of the resonator element 10, and the respective second end portions are connected to the package 20. The lead wires 15A, 15B, 16A and 16B are affixed by a support substrate 22 provided such that those second end portions are sandwiched between the support substrate 22 and the package 20.

The lead wires 15A, 15B, 16A and 16B are formed such that the gyro resonator element 10 may not be in touch with the support substrate 22 and the package 20. To this end, both end portions of each of the lead wires 15A and 15B are connected by a connecting portion which is inclined so as to extend in the Z direction as well as in the X direction in a way that the distance between the first end portions of the two lead wires in the X direction is smaller than that between the second end portions, and the first end portions are positioned on a first plane (plane of resonator element 10) while the second end portions are positioned on a second plane (bottom surface 21 of the package 20) spaced apart in the Z direction from the first plane. The same applies to the lead wires 16A and 16B if the Y direction is substituted for the X direction.

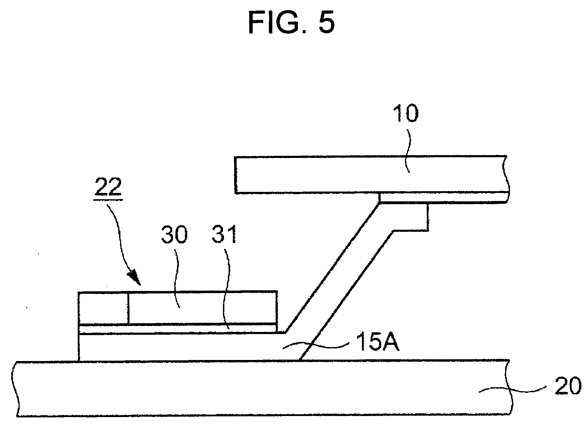

The support substrate 22 comprises, for example, as shown in the enlarged sectional view in FIG. 5, a stainless steel plate 30 having an insulating layer 31 of a polyimide resin or the like formed on the surface side thereof that faces the bottom surface 21 of the package 20. The lead wires 15A, 15B, 16A and 16B are affixed to the insulating layer 31 and sandwiched between the latter and the bottom surface 21. A central opening part 18 (FIG. 1(A)) is formed in the support substrate 22 to allow the connecting portions of the lead wires to pass through. Further, cut-outs 23, 24, 25, 26 are provided at the outer peripheral portions of the support substrate 22 in the vicinity of the outermost end of the second end portion of each of the lead wires.

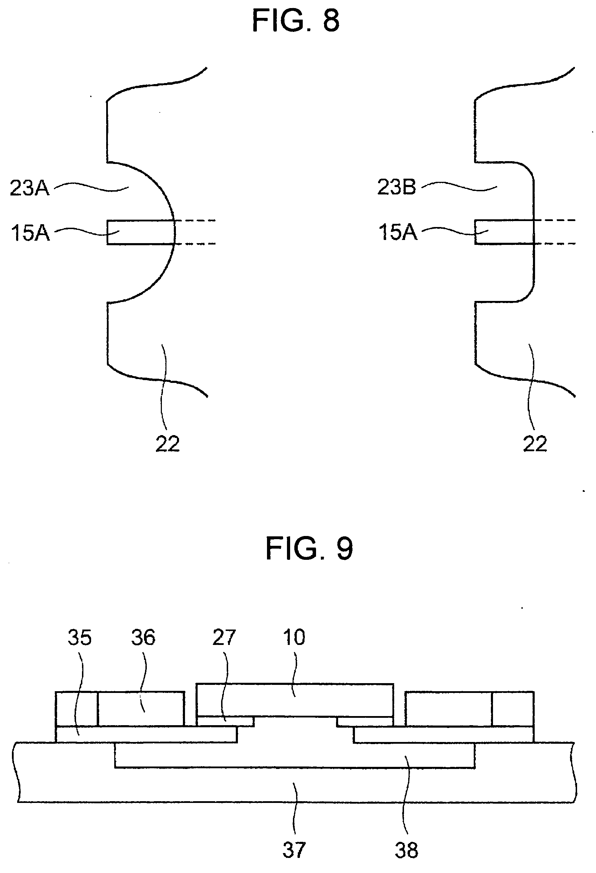

As shown in FIG. 8, as regards the shape of the cut-outs 23, 24, 25, and 26, they may have a semicircular shape, a substantially rectangular shape with rounded corners or the like, or any other shape as long as they does not hinder connecting the second end portion of a respective lead wire to the package 20.

As mentioned above, according to the gyro sensor 100 of the first embodiment, since the lead wires are affixed to a lower surface of the support substrate 22, that is, the surface that faces the package 20, it is possible to affix the lead wires to the package 20 without subjecting the lead wires to the lead forming as defined above.

Further, by receiving the Au splash on the support substrate which is on an upper surface of the lead wires, the Au splash is prevented from depositing on the lead wires, thus making it possible to prevent a short circuits between lead wires.

### Manufacturing Method of the Gyro Sensor

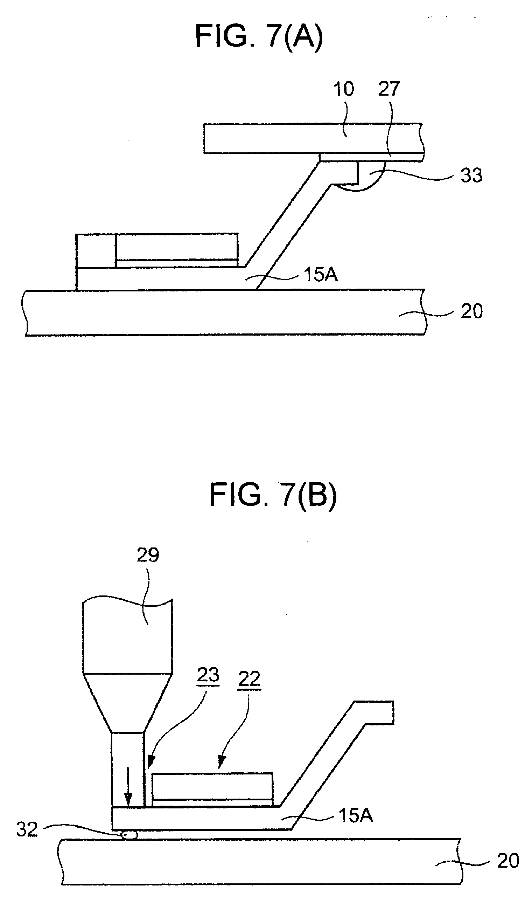

Referring to FIG. 7, an example of the manufacturing method of a gyro sensor of this invention will be described. FIG. 7 presents a diagram showing connections of both end portions of the lead wire 15A as being representative for all lead wires 15A, 15B, 16A, 16B.

First, though not illustrated, the lead wires affixed to the support substrate 22 are formed into a prescribed shape at the cut-out of the support substrate 22.

Next, as shown in FIG. 7(A), connection among the lead wires and the gyro resonator element 10 are made. The lead wires, one end portion of which being supported on the package 20, have the gyro resonator element 10 placed on the other end portions, and after coating a conductive bond 33, they are dried and connected to support electrodes 27 of the gyro resonator element 10.

Subsequently, as shown in FIG. 7(B), the formed lead wires are affixed to the package 20. To be specific, for example, Au bumps 32 are placed on the package 20, and the lead wires are placed on the Au bumps 32, respectively. At this point, a heating tool 29 or the like is inserted into each cut-out (23-26), and the lead wires, the Au bumps 32, and the package are affixed by applying pressure while heating them.

Although it has been described above that after first connecting the gyro resonator element to the lead wires, the lead wires are affixed to the package, the processing sequence may well be the reverse, so that after first connecting the lead wires to the package, the gyro resonator element may be affixed to the lead wires.

According to this method, since it is possible to put the heating tool in direct touch with the lead wires, heating efficiency may be enhanced. Also, stable affixing work can be performed.

### Second Embodiment

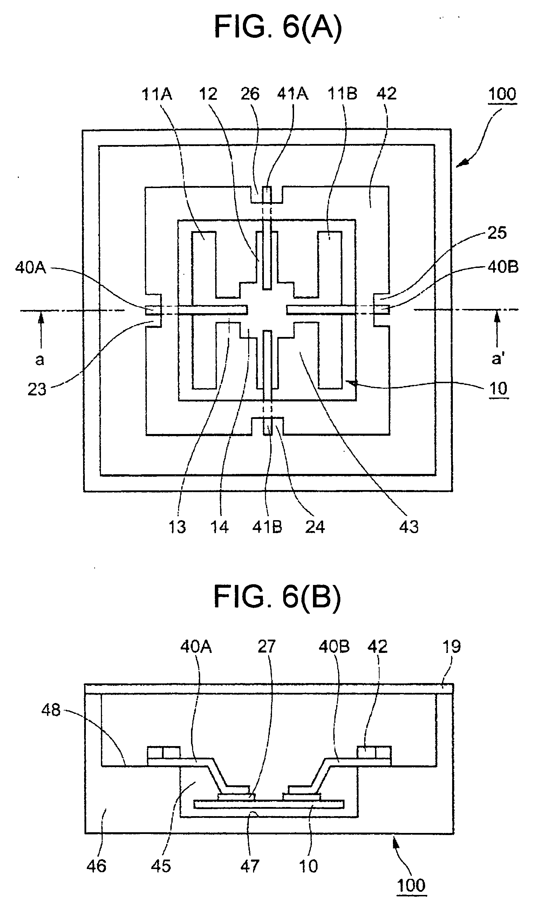

A second embodiment will be described using FIG. 6(A) and FIG. 6(B). FIG. 6(A) is a plan view and FIG. 6(B) is a front sectional view along line a-a' in FIG. 6(A) of a gyro sensor as an example of the piezo-electric device according to the second embodiment.

The gyro sensor configuration in this embodiment is the same as that described above for the first embodiment. Also, the configuration of the resonator element is the same as that in the first embodiment.

### Holding Structure of a Resonator element

The lead wires 40A and 40B extending in the X direction and 41A and 41B extending in the Y direction correspond to the lead wires 15A, 15B, 16A and 16B, respectively, of the first embodiment. They are band or stripe like members having either the same shape or different shapes. A first end portion of each of these lead wires is, as shown in FIG. 6(B), connected to one side of the support plate 14, and the second end portions are connected to the package 46. The lead wires 40A, 40B, 41A and 41B are affixed by a support substrate 42 provided so as to hold the lead wires on the package 46.

The lead wires 40A, 40B, 41A and 41 B are formed such that the gyro resonator element 10 may not be in touch with the package 46 but be positioned on a concave part 45 provided in the bottom surface 48 of the package 46. To this end, both end portions of each of the lead wires 40A and 40B are connected by a connecting portion which is inclined so as to extend in the Z direction as well as in the X direction in a way that the distance between the first end portions of the two lead wires in the X direction is smaller than that between the second end portions and the first end portions are positioned on a first plane (plane of resonator element 10) while the second end portions are positioned on a second plane (bottom surface 48 of the package 46) spaced apart in the Z direction from the first plane. The same applies to the lead wires 41A and 41 B if the Y direction is substituted for the X direction.

The support substrate 41 comprises, for example, a stainless steel plate having an insulating layer of a polyimide resin or the like formed on the surface side that faces the bottom surface 48 of the package 46. The lead wires 40A, 40B, 41A and 41B are affixed to the insulating layer and sandwiched between the latter and the bottom surface 48 of the package 46. A central opening 43 (FIG. 6(A)) is formed in the support substrate 42 for forming the lead wires. Furthermore, cut-outs 23, 24, 25, and 26 are provided in the same way as has been described for the first embodiment. The description regarding the first embodiment of possible shapes for the these cut-outs applies to this second embodiment in the same way.

As mentioned above, according to the gyro sensor of this second embodiment, since the lead wires are affixed to a lower surface of the support substrate 42, namely, the surface that faces the package 46, it is possible to closely adhere the lead wires to the package 46 without subjecting the lead wires to lead forming.

An alternative is shown in a front sectional view of FIG. 9. This alternative configuration uses a shape without bending the lead wires (one lead wire 35 being shown as representative of four lead wires corresponding to those mentioned above), namely, a first end portion of the lead wires is affixed to the gyro resonator element 10 and the second end portion of the lead wires is affixed to the surface side of the support substrate 36 that faces the package 37 and extends at the same level as the gyro resonator element 10 such that the lead wires are plane.

According to such configuration, it is possible to adhere the lead wires closely to the package 37 without subjecting the lead wire 35 to lead forming at connecting sections with the package. Also at the connecting sections with the resonator element lead forming of the lead wires becomes unnecessary, thus making it possible to improve ease of processing lead wires.

### Other Embodiments

FIG. 10 is a front sectional view showing a configuration of a piezoelectric oscillator of this invention.

According to FIG. 10, the piezoelectric oscillator 50 comprises a piezoelectric resonator element 60, a plurality of lead wires 55A and 55B (in this example, two wires of 55A and 55B will be described) which are a support mechanism to hold the piezoelectric resonator element 60, a package 58, for example, a ceramic package for the piezoelectric resonator element 60 to be placed in through the lead wires 55A and 55B, a support substrate 56 to support the lead wires 55A and 55B, a circuit element 57 having a function to oscillate the piezoelectric resonator element 60, and a cover 59 for housing members such as the piezoelectric resonator element 60 in the package 58.

The lead wires 55A and 55B are affixed by a support substrate 56 provided in a positional relationship of holding the lead wires 55A and 55B onto the package 58.

The lead wires 55A and 55B are formed such that the piezoelectric resonator element 60 may not be in touch with the package 58 or the circuit element 57 and the like but be positioned inside the package 58. To be more specific, the lead wires 55A and 55B are shaped in the same way as has been described in detail for the lead wires 15A and 15B in the context of the first embodiment.

According to the piezoelectric oscillator of the above-mentioned configuration, since the lead wires are affixed to the lower surface of the support substrate 56, namely, the surface facing the package 58, it is possible to adhere the lead wires closely to the package 58 without subjecting the lead wires to lead forming.

The piezo-electric resonator element or the piezoelectric oscillator of this invention may be used in, for example, electronic equipment such as mobile phones, video cameras, digital cameras, and personal computers, for a control reference signal, a reference signal of clock function, or a sensor and the like.

According to this invention, by using a low-cost piezoelectric device and a piezoelectric oscillator, it is possible to provide low-cost electronic equipment.

## Claims

1. A piezoelectric device comprising:
- a piezoelectric resonator element (10);
- a lead wire (15A, 15B, 16A, 16B) holding the piezoelectric resonator element (10), one end portion of the lead wire being connected to the piezoelectric resonator element (10); and
- a support substrate (22) supporting the lead wire (15A, 15B, 16A, 16B), wherein the other end portion of the lead wire (15A, 15B, 16A, 16B) is affixed to a lower surface of the support substrate (22) that faces away from the resonator element (10),
**characterized in that** the lead wire (15A, 15B, 16A, 16B; 40A, 40B, 41A, 41 B) comprises a connecting portion configured to connect said two end portions,
said connecting portion being inclined with respect to the end portions such that said two end portions are positioned in two different planes spaced apart from each other in a direction (Z) substantially perpendicular to these planes, and the end portions are displaced relative to each other in a direction (X; Y) parallel to said planes.

2. The piezoelectric device according to claim 1, wherein the support substrate (22) and the piezoelectric resonator element (10) are disposed with a gap therebetween.

3. The piezoelectric device according to claim 1 or 2, wherein the resonator element (10) and the support substrate (22) are on the same side of the lead wire (15A, 15B, 16A, 16B).

4. The piezoelectric device according to any one of claim 1 to 3, wherein the support substrate (22) has a cut-out (23-26) in registration with part of said other end portion of the lead wire (15A, 15B, 16A, 16B) affixed to the support substrate (22).

5. The piezoelectric device according to any one of claims 1 to 4, wherein the support substrate (22) has a central opening (18) through which said connecting portion of the lead wire (15A, 15B, 16A, 16B) penetrates the support substrate (22).

6. The piezoelectric device according to any one of claims 1 to 5, wherein the support substrate (22) comprises a conductive thin plate (30) and an insulating layer (31), and the lead wire (15A, 15B, 16A, 16B) is affixed to the insulating layer.

7. The piezoelectric device according to any one of claims 1 to 6, wherein the resonator element (10) is a resonator element for a gyro sensor adapted to detect a rotary angular velocity.

8. The piezoelectric device according to any one of claims 1 to 7, further having a circuit element (57) having a function of oscillating the resonator element (60).

9. A method of manufacturing a piezoelectric device , wherein the piezoelectric device comprises a piezoelectric resonator element (10), a lead wire (15A, 15B, 16A, 16B) holding the piezoelectric resonator element (10), and a support substrate (22) supporting the lead wire (15A, 15B, 16A, 16B) the method comprising:
- connecting the resonator element (10) to one end of the lead wire (15A, 15B, 16A, 16B; 40A, 40B, 41A, 41B); and
- affixing the other end portion of the lead wire (15A, 15B, 16A, 16B) to a lower surface of the support substrate (22) that faces away from the resonator element (10),
wherein the lead wire (15A, 15B, 16A, 16B; 40A, 40B, 41A, 41 B) comprises a connecting portion that connects said two end portions, said connecting portion being inclined with respect to the end portions such that said two end portions are positioned in two different planes spaced apart from each other in a direction (Z) substantially perpendicular to these planes, and the end portions are displaced relative to each other in a direction (X; Y) parallel to said planes.

10. Electronic equipment having a piezoelectric device according to any one of claims 1 to 8.

## Patentansprüche

1. Piezoelektrische Vorrichtung, umfassend:
- ein piezoelektrisches Resonanzelement (10);
- einen das piezoelektrische Resonanzelement (10) haltenden Leitungsdraht (15A, 15B, 16A, 16B), wobei ein Endteil des Leitungsdrahts mit dem piezoelektrischen Resonanzelement (10) verbunden ist; und
- ein den Leitungsdraht (15A, 15B, 16A, 16B) stützendes Stützsubstrat (22), wobei der andere Endteil des Leitungsdrahts (15A, 15B, 16A, 16B) an einer unteren Fläche des Stützsubstrats (22), die vom Resonanzelement (10) weg zeigt, befestigt ist,
**dadurch gekennzeichnet, dass** der Leitungsdraht (15A, 15B, 16A, 16B; 40A, 40B, 41A, 41 B) einen zum Verbinden der zwei Endteile ausgebildeten Verbindungsteil umfasst,
wobei der Verbindungsteil in Bezug auf die Endteile geneigt ist, so dass die zwei Endteile in zwei unterschiedlichen Ebenen mit einem Abstand zueinander in einer Richtung (Z) im Wesentlichen senkrecht zu diesen Ebenen angeordnet sind und die Endteile in Bezug zueinander in einer Richtung (X; Y) parallel zu den Ebenen versetzt sind.

2. Piezoelektrische Vorrichtung nach Anspruch 1, wobei das Stützsubstrat (22) und das piezoelektrische Resonanzelement (10) mit einem Spalt dazwischen angeordnet sind.

3. Piezoelektrische Vorrichtung nach Anspruch 1 oder 2, wobei sich das Resonanzelement (10) und das Stützsubstrat (22) auf der gleichen Seite des Leitungsdrahts (15A, 15B, 16A, 16B) befinden.

4. Piezoelektrische Vorrichtung nach einem der Ansprüche 1 bis 3, wobei das Stützsubstrat (22) einen Ausschnitt (23-26) in Ausrichtung mit einem Teil des am Stützsubstrat (22) befestigten anderen Endteils des Leitungsdrahts (15A, 15B, 16A, 16B) aufweist.

5. Piezoelektrische Vorrichtung nach einem der Ansprüche 1 bis 4, wobei das Stützsubstrat (22) eine zentrale Öffnung (18) aufweist, durch die der Verbindungsteil des Leitungsdrahts (15A, 15B, 16A, 16B) das Stützsubstrat (22) durchdringt.

6. Piezoelektrische Vorrichtung nach einem der Ansprüche 1 bis 5, wobei das Stützsubstrat (22) eine leitfähige dünne Platte (30) und eine Isolierschicht (31) umfasst und der Leitungsdraht (15A, 15B, 16A, 16B) an der Isolierschicht befestigt ist.

7. Piezoelektrische Vorrichtung nach einem der Ansprüche 1 bis 6, wobei das Resonanzelement (10) ein Resonanzelement für einen zum Erkennen einer Drehwinkelgeschwindigkeit ausgebildeten Kreiselsensor ist.

8. Piezoelektrische Vorrichtung nach einem der Ansprüche 1 bis 7, ferner aufweisend ein Schaltkreiselement (57), das eine Funktion hat, das Resonanzelement (60) in Schwingung zu versetzen.

9. Verfahren zum Herstellen einer piezoelektrischen Vorrichtung, wobei die piezoelektrische Vorrichtung ein piezoelektrisches Resonanzelement (10), einen das piezoelektrische Resonanzelement (10) haltenden Leitungsdraht (15A, 15B, 16A, 16B) und ein den Leitungsdraht (15A, 15B, 16A, 16B) stützendes Stützsubstrat (22) umfasst,
wobei das Verfahren Folgendes umfasst:
- Verbinden des Resonanzelements (10) mit einem Ende des Leitungsdrahts (15A, 15B, 16A, 16B, 40A, 40B, 41A, 41 B); und
- Verbinden des anderen Endteils des Leitungsdrahts (15A, 15B, 16A, 16B) mit einer unteren Fläche des Stützsubstrats (22), die vom Resonanzelement (10) weg zeigt,
wobei der Leitungsdraht (15A, 15B, 16A, 16B, 40A, 40B, 41 A, 41 B) einen Verbindungsteil umfasst, der die zwei Endteile verbindet, wobei der Verbindungsteil in Bezug auf die Endteile geneigt ist, so dass die zwei Endteile in zwei unterschiedlichen Ebenen mit einem Abstand zueinander in einer Richtung (Z) im Wesentlichen senkrecht zu diesen Ebenen angeordnet sind und die Endteile in Bezug zueinander in einer Richtung (X; Y) parallel zu den Ebenen versetzt sind.

10. Elektronische Ausrüstung mit einer piezoelektrischen Vorrichtung nach einem der Ansprüche 1 bis 8.

## Revendications

1. Dispositif piézoélectrique comprenant :
- un élément de résonateur piézoélectrique (10) ;
- un fil conducteur (15A, 15B, 16A, 16B) maintenant l'élément de résonateur piézoélectrique (10), une partie d'extrémité du fil conducteur étant connectée à l'élément de résonateur piézoélectrique (10) ; et
- un substrat de support (22) portant le fil conducteur (15A, 15B, 16A, 16B), l'autre partie d'extrémité du fil conducteur (15A, 15B, 16A, 16B) étant fixée à une surface inférieure du substrat de support (22) qui est opposée à l'élément de résonateur (10),
**caractérisé par le fait que** le fil conducteur (15A, 15B, 16A, 16B ; 40A, 40B, 41A, 41B) comprend une partie de connexion configurée pour connecter lesdites deux parties d'extrémité, ladite partie de connexion étant inclinée par rapport aux parties d'extrémité de telle sorte que lesdites deux parties d'extrémité sont positionnées dans deux plans différents espacés l'un de l'autre dans une direction (Z) sensiblement perpendiculaire à ces plans, et les parties d'extrémité sont déplacées l'une par rapport à l'autre dans une direction (X ; Y) parallèle auxdits plans.

2. Dispositif piézoélectrique selon la revendication 1, dans lequel le substrat de support (22) et l'élément de résonateur piézoélectrique (10) sont disposés avec un espace entre ceux-ci.

3. Dispositif piézoélectrique selon la revendication 1 ou 2, dans lequel l'élément de résonateur (10) et le substrat de support (22) sont sur le même côté du fil conducteur (15A, 15B, 16A, 16B).

4. Dispositif piézoélectrique selon l'une quelconque des revendications 1 à 3, dans lequel le substrat de support (22) possède une découpe (23-26) en coïncidence avec une partie de ladite autre partie d'extrémité du fil conducteur (15A, 15B, 16A, 16B) fixée au substrat de support (22).

5. Dispositif piézoélectrique selon l'une quelconque des revendications 1 à 4, dans lequel le substrat de support (22) possède une ouverture centrale (18) à travers laquelle ladite partie de connexion du fil conducteur (15A, 15B, 16A, 16B) pénètre dans le substrat de support (22).

6. Dispositif piézoélectrique selon l'une quelconque des revendications 1 à 5, dans lequel le substrat de support (22) comprend une plaque mince conductrice (30) et une couche d'isolation (31), et le fil conducteur (15A, 15B, 16A, 16B) est fixé à la couche d'isolation.

7. Dispositif piézoélectrique selon l'une quelconque des revendications 1 à 6, dans lequel l'élément de résonateur (10) est un élément de résonateur pour un capteur gyroscope conçu pour détecter une vitesse angulaire de rotation.

8. Dispositif piézoélectrique selon l'une quelconque des revendications 1 à 7, ayant en outre un élément de circuit (57) ayant une fonction d'oscillation de l'élément de résonateur (60).

9. Procédé de fabrication d'un dispositif piézoélectrique, dans lequel le dispositif piézoélectrique comprend un élément de résonateur piézoélectrique (10), un fil conducteur (15A, 15B, 16A, 16B) maintenant l'élément de résonateur piézoélectrique (10), et un substrat de support (22) portant le fil conducteur (15A, 15B, 16A, 16B),
le procédé comprenant :
- la connexion de l'élément de résonateur (10) à une extrémité du fil conducteur (15A, 15B, 16A, 16B ; 40A, 40B, 41A, 41B) ; et
- la fixation de l'autre partie d'extrémité du fil conducteur (15A, 15B, 16A, 16B) à une surface inférieure du substrat de support (22) qui est opposée à l'élément de résonateur (10),
dans lequel le fil conducteur (15A, 15B, 16A, 16B ; 40A, 40B, 41A, 41B) comprend une partie de connexion qui connecte lesdites deux parties d'extrémité, ladite partie de connexion étant inclinée par rapport aux parties d'extrémité de telle sorte que lesdites deux parties d'extrémité sont positionnées dans deux plans différents espacés l'un de l'autre dans une direction (Z) sensiblement perpendiculaire à ces plans, et les parties d'extrémité sont déplacées l'une par rapport à l'autre dans une direction (X ; Y) parallèle auxdits plans.

10. Equipement électronique ayant un dispositif piézoélectrique selon l'une quelconque des revendications 1 à 8.
